(19) Europäisches Patentamt
European Patent Office
Office européen des brevets

(11) EP 2 289 958 B1

(12) # EUROPEAN PATENT SPECIFICATION

(45) Date of publication and mention of the grant of the patent:
**01.10.2014 Bulletin 2014/40**

(21) Application number: **09766702.6**

(22) Date of filing: **18.06.2009**

(51) Int Cl.:
***C08F 290/06*** (2006.01) ***C08G 65/40*** (2006.01)
***C09D 4/06*** (2006.01) ***C08F 251/00*** (2006.01)

(86) International application number:
**PCT/JP2009/061115**

(87) International publication number:
**WO 2009/154254 (23.12.2009 Gazette 2009/52)**

(54) **CURABLE COMPOSITION AND CURED FILM USING SAME**

HÄRTBARE ZUSAMMENSETZUNG UND GEHÄRTETER FILM DARAUS

COMPOSITION DURCISSABLE ET FILM DURCI L'UTILISANT

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **19.06.2008 JP 2008160197**

(43) Date of publication of application:
**02.03.2011 Bulletin 2011/09**

(73) Proprietor: **Asahi Glass Company, Limited**
**Chiyoda-ku**
**Tokyo 100-8405 (JP)**

(72) Inventors:
- **ITO, Masahiro**
**Tokyo 100-8405 (JP)**
- **ERIGUCHI, Takeshi**
**Tokyo 100-8405 (JP)**
- **ISHIBASHI, Yuichiro**
**Tokyo 100-8405 (JP)**
- **TSURUOKA, Kaori**
**Tokyo 100-8405 (JP)**
- **ABE, Takefumi**
**Tokyo 100-8405 (JP)**

(74) Representative: **Müller-Boré & Partner Patentanwälte PartG mbB**
**Friedenheimer Brücke 21**
**80639 München (DE)**

(56) References cited:
**EP-A1- 1 897 897**
**JP-A- 2007 186 608**
**JP-A- 2007 186 608**
**JP-A- 2007 188 741**
**JP-A- 2007 188 741**
**US-A- 5 250 667**
**US-A1- 2005 107 569**

EP 2 289 958 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Printed by Jouve, 75001 PARIS (FR)

## Description

### TECHNICAL FIELD

The present invention relates to a curable composition and a cured film obtainable by curing such a curable composition.

### BACKGROUND ART

In the electronics field, development of insulating materials having low dielectric constants is advancing. Particularly, a polyarylene resin has been proposed as a material excellent in application to an interlayer dielectric film for semiconductor devices, a stress relaxation layer for a redistribution layer, (Patent Documents 1 to 3).

Further, a highly transparent low-dielectric-constant polyarylene resin has been proposed as an embedding material at the time of forming individual pixels in a process for producing TFT (thin film transistor) (Patent Document 4). By using a highly transparent low-dielectric-constant material, it becomes possible to improve the response properties of a device and to increase the numerical aperture.

Further, a photocurable composition has been proposed wherein a polyarylene resin has been provided with photosensitivity (Patent Documents 5 and 6). With such photosensitivity, fine processing by photolithography becomes possible in the same manner as e.g. a resist. Accordingly, it has a merit, for example, such that a contact hole can easily be formed in an interlayer dielectric film made of such a polyarylene resin.

### PRIOR ART DOCUMENTS

### PATENT DOCUMENTS

Patent Document 1: U.S. Patent No. 6,361,926
Patent Document 2: WO03/8483
Patent Document 3: JP-A-10-74750
Patent Document 4: WO2006/137327
Patent Document 5: JP-A-7-503740
Patent Document 6: WO2007/119384
Patent Document 7: JP A 2007186 608Patent Document 8: JP A 2007188741Patent Document 9: EP A 1897897Patent Document 10: US A 5250667Patent Document 11: US 2005/107569 A

### DISCLOSURE OF THE INVENTION

### PROBLEMS TO BE SOLVED BY THE INVENTION

However, when these polyarylene resins are practically applied to semiconductor devices, there is a problem that the embedding planarity is not necessarily sufficient. The embedding planarity is a performance as to how flat a film surface can be made when a film is formed on a concavoconvex substrate surface. When the embedding planarity is excellent, a flat surface can easily be obtained even if the film thickness is thin. When the film thickness can be made thin, the degree of freedom in designing devices can be improved and at the same time, it is possible to reduce the cost for the material.

Further, when a flat surface can be obtained easily, the degree of freedom in optical designs can be increased. For example, in the case of an optical thin film such as an anti-reflection film, if a sufficiently high planarity is not obtained, the antireflection performance becomes non-uniform in a plane. Further, depending upon the sizes of convexoconcaves, interference fringes are likely to appear, whereby an expected performance cannot be obtained. Further, in a light guide element such as an optical waveguide, if convexoconcaves are present at the interface of the light path, light is likely to leak, thus leading to a transmission loss. In a case where an optical element is formed on a polished flat substrate, such problems are less likely to occur. However, in the case of an optical element to be formed directly on the surface of a semiconductor device, like an optical sensor, the production process can be substantially simplified if it is possible to form a flat surface having high planarity without necessity to polish the surface. Further, in a case where optical waveguides, are to be produced in multilayers at a high density, a high level of planarity is required to prevent mutual interference.

That is , a curable composition is desired whereby a cured film having a low dielectric constant can be obtained

and the embedding planarity at the time of film formation is excellent.

The present invention has been made under the above described circumstances, and it is an object of the present invention to provide a curable composition whereby a cured film having a low dielectric constant can be obtained and the embedding planarity at the time of film formation is excellent, and a cured film obtained by using such a curable composition.

## MEANS TO SOLVE THE PROBLEMS

The curable composition of the present invention according to claims 1 to 8 comprises a fluorinated polyarylene prepolymer (A) having a crosslinkable functional group, and a compound (B), having a crosslinkable functional group and having no fluorine atoms.

The proportion of the fluorinated polyarylene prepolymer (A) is preferably from 3 to 97 mass%, based on the total mass of the fluorinated polyarylene prepolymer (A) and the compound (B).

The compound (B) preferably has at least two crosslinkable functional groups.

The crosslinkable functional group of the compound (B), includes at least one type selected from the group consisting of a vinyl group, an allyl group, an ethynyl group, a vinyloxy group, an allyloxy group, an acryloyl group, an acryloyloxy group, a methacryloyl group and a methacryloyloxy group.

The curable composition of the present invention may further contain a photosensitizer and a solvent.

Further, the present invention provides a cured film according to claims 9 to 12 obtainable by curing the curable composition of the present invention.

Further, the curing of the curable composition of the present invention is preferably carried out by heating or light irradiation.

## ADVANTAGEOUS EFFECT OF THE INVENTION

By the curable composition of the present invention, a cured film having a low dielectric constant can be obtained, and it is excellent in an embedding planarity at the time of film formation.

The cured film of the present invention has a low dielectric constant and is excellent in the planarity of the film surface even when formed on a substrate surface having convexoconcaves.

## BEST MODE FOR CARRYING OUT THE INVENTION

In the present application, the molecular weight is a formula weight obtainable based on the chemical formula. However, in a case where a molecular weight distribution is present, it means a number average molecular weight.

### <Fluorinated polyarylene prepolymer (A)>

The fluorinated polyarylene prepolymer (A) (which may be hereinafter referred to simply as a prepolymer (A)) has a polyarylene structure wherein a plurality of aromatic rings are bonded via a single bond or a linking group, and at the same time it has fluorine atoms and a crosslinkable functional group.

The linking group in the polyarylene structure may, for example, be an ether bond (-O-), a sulfide bond (-S-), a carbonyl group (-CO-) or a bivalent group ($-SO_2-$) having a hydroxy group removed from a sulfonic acid group. Among prepolymers (A), one having a structure wherein aromatic rings are bonded to one another by a linking group including an ether bond (-O-) is referred to as a fluorinated polyarylene ether prepolymer (A1). In the present invention, the prepolymer (A) is a concept including such a fluorinated polyarylene ether prepolymer (A1).

As a specific example of such a linking group containing an ether bond, an ether bond (-O-) composed solely of an etheric oxygen atom or an alkylene group containing an etheric oxygen atom in its carbon chain may, for example, be exemplified.

The crosslinkable functional group of the prepolymer (A) is a reactive functional group which undergoes substantially no reaction at the time of producing the prepolymer, and which undergoes a reaction to cause crosslinking or chain extension between prepolymer molecules, by addition of an external energy, at the time of producing a cured product such as a membrane, film or molded product, or at an optional time after the production.

The external energy may, for example, be heat, light or electron beams. They may be used in combination. When heat is used as the external energy, the reactive functional group is preferably one which reacts at a temperature of from 40°C to 500°C. If the reaction temperature is too low, it is not possible to secure the stability during the storage of the prepolymer or a coating composition containing the prepolymer, and if it is too high, the heat decomposition of the prepolymer itself takes place. Therefore, the temperature is preferably in the above range. With a view to reducing a thermal load exerted to e.g. semiconductor devices to which the curable composition of the present invention is applied,

a reactive group which reacts at a temperature of from 60°C to 300°C is more preferred, and a reactive group which reacts at a temperature of from 70°C to 200°C is most preferred.

When light (actinic rays) is used as the external energy, it is preferred to incorporate a photosensitizer in the prepolymer or in the curable composition containing the prepolymer. In such a case, in the step of exposure, by selectively irradiating the prepolymer with actinic rays, it is possible to make the prepolymer at the exposed portion have a high molecular weight. Even after the steps of exposure and development, if necessary, it is possible to make the prepolymer have a higher molecular weight by applying the external energy such as actinic rays or heat.

Specific examples of the crosslinkable functional group are a vinyl group, an allyl group, a methacryloyl(oxy) group, an acryloyl(oxy) group, a vinyloxy group, a trifluorovinyl group, a trifluorovinyloxy group, an ethynyl group, a 1-oxocyclopenta-2,5-dien-3-yl group, a cyano group, an alkoxysilyl group, a diarylhydroxymethyl group, a hydroxyfluorenyl group, a cyclobutarene ring and an oxirane ring. A vinyl group, a methacryloyl(oxy) group, an acryloyl(oxy) group, a trifluorovinyloxy group, an ethynyl group, a cyclobutarene ring or an oxirane ring is preferred from such a viewpoint that the reactivity is high, and a high crosslink density can be obtained. And a vinyl group or an ethynyl group is most preferred from such a viewpoint that a cured film thereby obtainable will have good heat resistance. Here, a methacryloyl(oxy) group means a methacryloyl group or a methacryloyloxy group, and the same applies to an acryloyl(oxy) group.

The number average molecular weight of the prepolymer (A) is within a range of from $1\times10^3$ to $5\times10^5$, preferably from $1.5\times10^3$ to $1\times10^5$. As it has such a molecular weight, the after-described coating properties of the curable composition containing the prepolymer (A) will be good, and the cured film thereby obtainable will have good heat resistance, mechanical properties, solvent resistance, etc.

The prepolymer (A) has an aromatic ring, whereby the heat resistance is good, and for example, high reliability is obtainable in a case where it is used as a constituting component of a semiconductor device.

Among prepolymers (A), a fluorinated polyarylene ether prepolymer (A1) is particularly preferred in that it has an etheric oxygen atom, whereby the molecular structure has flexibility, and the flexibility of the resin is good.

The prepolymer (A) has fluorine atoms. As it has fluorine atoms, the dielectric constant and the dielectric loss of a cured film tends to be low, such being desirable as a material to form an insulating film. When the dielectric constant and dielectric loss of an insulating film are low, it is possible to prevent delay of a signal propagation velocity and to obtain a device excellent in electrical properties.

Further, as it has fluorine atoms, the water absorption of the cured film becomes low, whereby it is possible to prevent a change in the bonded state at the bonded electrodes and wiring portions therearound, or it is possible to prevent modification (such as rusting) of metals, and it presents a substantial effect to improve the reliability of a device.

A preferred example of such a prepolymer (A) may be a prepolymer obtainable by reacting, in the presence of a dehydro halogenating agent such as potassium carbonate, a fluorinated aromatic compound such as perfluoro(1,3,5-triphenylbenzene) or perfluorobiphenyl, a phenolic compound such as 1,3,5-trihydroxybenzene or 1,1,1-tris(4-hydroxyphenyl)ethane, and a crosslinkable compound such as pentafluorostyrene, acetoxystyrene or chloromethylstyrene.

<Compound (B)>

The compound (B) has a molecular weight of from 140 to 5,000, has a crosslinkable functional group and has no fluorine atoms.

As it has no fluorine atoms, a good embedding planarity can easily be obtained, and it tends to be inexpensive as compared with a fluorinated compound.

When the molecular weight of the compound (B) is at most 5,000, the viscosity of the compound (B) can be controlled to be low, and a uniform curable composition can easily be obtainable when it is mixed with the prepolymer (A). Further, a good planarity is thereby easily obtainable.

When the molecular weight of the compound (B) is at least 140, good heat resistance can be obtained, and decomposition or evaporation by heating is less likely to occur.

The range of the molecular weight of the compound (B) is preferably from 300 to 3,000, particularly preferably from 500 to 2,500.

The crosslinkable functional group of the compound (B) contains no fluorine atoms and is preferably a reactive functional group which reacts in the same step as the step of reacting the above-mentioned crosslinkable functional group of the prepolymer (A).

The crosslinkable functional group of the compound (B) at least undergoes a reaction with the compound (B) to cause crosslinking or chain extension. The crosslinkable functional group of the compound (B) preferably undergoes a reaction with both the prepolymer (A) and the compound (B) to cause crosslinking or chain extension.

The crosslinkable functional group of the compound (B) is preferably a double bond or a triple bond between carbon atoms. However, it does not include an aromatic double bond or triple bond. The double bond or triple bond as the crosslinkable functional group may be present in the interior of the molecular chain or may be present at the terminal. However, it is preferably present at the terminal, since the reactivity is thereby high. In the case of a double bond, the

compound may be an internal olefin or a terminal olefin, preferably a terminal olefin. "Be present in the interior of the molecular chain" includes a case where it is present on a part of an alicyclic ring such as a cycloolefin.

Specifically, the crosslinkable functional group preferably includes at least one type selected from the group consisting of a vinyl group, an allyl group, an ethynyl group, a vinyloxy group, an allyloxy group, an acryloyl group, an acryloyloxy group, a methacryloyl group and a methacryloyloxy group. Among them, an acryloyl group or an acryloyloxy group is preferred in that it undergoes a reaction by light irradiation even in the absence of a photosensitizer.

The crosslinkable functional group of the present invention is a functional group satisfying the above conditions and does not include, e.g. a functional group contributing to a Diels-Alder reaction. As the functional group contributing to the Diels-Alder reaction, a cyclopentadienone group (1-oxocyclopenta-2,5-dien-3-yl group) may, for example, be mentioned.

The compound (B) preferably has at least two, preferably from 2 to 20, particularly preferably from 2 to 8, crosslinkable functional groups. When it has at least two crosslinkable functional groups, it is capable of intermolecular crosslinking, whereby it is possible to improve the heat resistance of a cured film, and to satisfactorily prevent a reduction of the film thickness of the cured film by heating.

Specific examples of the compound (B) are, for example, dipentaerythritol triacrylate triundecylate, dipentaerythritol pentaacrylate monoundecylate, ethoxylated isocyanuric acid triacrylate, ε-caprolactone-modified tris-(2-acryloxyethyl) isocyanurate, dipentaerythritol polyacrylate, 9,9-bis[4-(2-acryloyloxyethoxy)phenyl]fluorene, polyethylene glycol diacrylate, polyethylene glycol dimethacrylate, polypropylene glycol diacrylate, polypropylene glycol dimethacrylate, ethoxylated bisphenol A diacrylate, ethoxylated bisphenol A dimethacrylate, propoxylated bisphenol A diacrylate, propoxylated bisphenol A dimethacrylate, 1,10-decanediol diacrylate, 1,6-hexanediol diacrylate, 1,6-hexanediol dimethacrylate, 1,4-butanediol dimethacrylate, 1,3-butanediol dimethacrylate, hydroxypivalic acid neopentyl glycol diacrylate, 1,9-nonanediol diacrylate, 1,9-nonanediol dimethacrylate, neopentyl glycol diacrylate, neopentyl glycol dimethacrylate, pentaerythritol triacrylate, trimethylolpropane triacrylate, trimethylolpropane trimethacrylate, ethoxylated trimethylolpropane triacrylate, propoxylated trimethylolpropane triacrylate, triallyl cyanurate, triallyl isocyanurate, trimethaallyl isocyanurate, 1,4-butanediol divinyl ether, 1,9-nonanediol divinyl ether, cyclohexane dimethanol divinyl ether, triethylene glycol divinyl ether, trimethylolpropane trivinyl ether, pentaerythritol tetravinyl ether, 2-(2-vinyloxyethoxy)ethyl acrylate, 2-(2-vinyloxyethoxy)ethyl methacrylate, trimethylolpropane diallyl ether, pentaerythritol triallyl ether, dipentaerythritol hexaacrylate, pentaerythritol tetraacrylate, propoxylated dipentaerythritol hexaacrylate, dioxane glycol diacrylate, an ethoxylated pentaerythritol tetraacrylate represented by the following formula (1), a propoxylated pentaerythritol tetraacrylate represented by the following formula (2), ditrimethylolpropane tetraacrylate, tricyclodecane dimethanol diacrylate, tricyclodecane dimethanol methacrylate, and a compound represented by the following formula (3). Further, polyester acrylates (a compound obtained by modifying both terminals of a condensate of a dihydric alcohol and a dibasic acid with acrylic acid: tradename Aronix (M-61 00, M-6200, M-6250 or M-6500), manufactured by TOAGOSEI CO., LTD.; and a compound obtained by modifying terminal hydroxy groups of a condensate of a polyhydric alcohol and a polybasic acid, with acrylic acid: tradename Aronix (M-7100, M-7300K, M-8030, M-8060, M-8100, M-8530, M-8560 or M-9050) manufactured by TOAGOSEI CO., LTD.) may also be used. These products are available as commercial products.

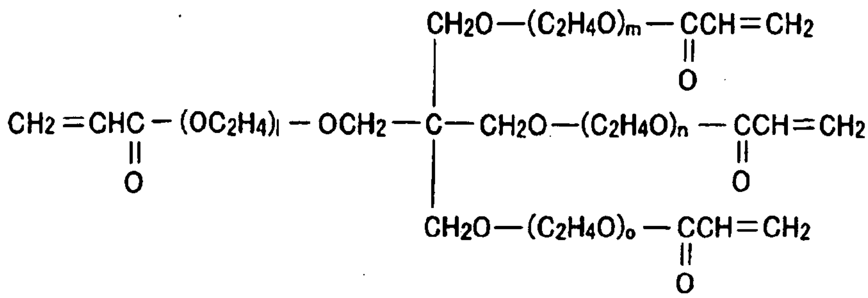

···(1)

(In the formula, l+m+n+o is from 4 to 35.)

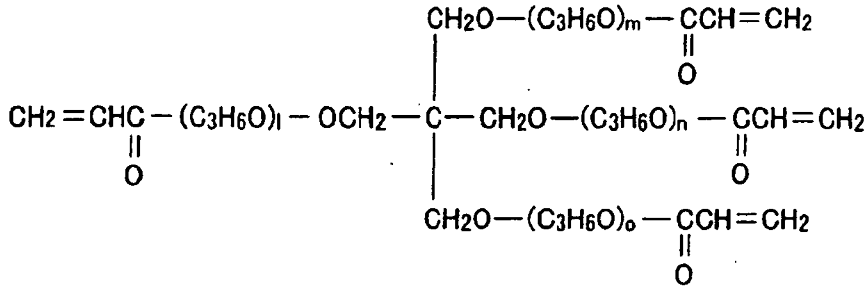

···(2)

(In the formula, l+m+n+o is about 4.)

(In the formula, R is

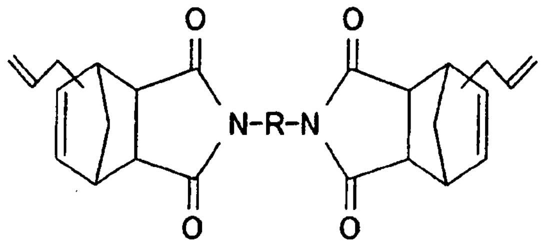

···(3)

As the curable composition contains the compound (B), a uniform curable composition is obtainable. Further, when such a curable composition is applied and cured, a layer having a high planarity will be formed. Further, by sufficiently carrying out the curing of such a curable composition, the crosslinking reaction will be sufficiently proceeded. As a result, a cured product having good heat resistance is obtainable.

The proportion of the prepolymer (A) is preferably from 3 to 97 mass%, more preferably from 40 to 95 mass%, further preferably from 40 to 80 mass%, based on the total mass of the prepolymer (A) and the compound (B).

As the proportion of the prepolymer (A) becomes large, the dielectric constant tends to be low, and a high heat resistance tends to be readily obtainable. As the proportion of the compound (B) becomes large, the embedding planarity tends to be good.

<Solvent>

The curable composition of the present invention may not necessarily contain a solvent, but preferably contains a solvent. As such a solvent, a known solvent may be used. As a specific example, propylene glycol monomethyl ether acetate (which may be hereinafter referred to as PGMEA) may, for example, be mentioned.

In the present invention, the content of the solvent in the curable composition is from 0 to 99 mass%, preferably from 20 to 85 mass%, based on the total amount of the curable composition (100 mass%).

<Photosensitizer>

The curable composition of the present invention may be photocurable. In order to impart the photocurability or improve the photocuring reactivity, it is preferred to incorporate a photosensitizer.

The photosensitizer may be one known for a photocurable composition.

Specific examples may, for example, be IRGACURE 907 ($\alpha$-aminoalkylphenone type), IRGACURE 369 ($\alpha$-aminoalkylphenone type), DAROCUR TPO (acylphosphine oxide type), IRGACURE OXE01 (oxime ester derivative), IRGACURE OXE02 (oxime ester derivative) (each manufactured by Ciba Specialty Chemicals K.K.). Among them, DAROCUR TPO, IRGACURE OXE01 or IRGACURE OXE02 is particularly preferred.

In a case where the curable composition of the present invention is a photocurable composition, it preferably contains not only a photosensitizer but also a solvent.

The contents of the photosensitizer and the solvent in the photocurable composition are such that based on the total amount (100 mass%) of the curable composition, the photosensitizer is from 0.1 to 20 mass%, preferably from 1 to 10 mass%, and the solvent is from 0 to 99 mass%, preferably from 20 to 85 mass%.

Here, the solvent may be any known solvent so long as it is able to dissolve the prepolymer (A) and the compound (B), and it may, for example, be mesitylene, N,N-dimethylacetamide, PGMEA, cyclohexanone or tetrahydrofuran. Among them, PGMEA or cyclohexanone is preferred.

<Heat curing accelerator>

The curable composition of the present invention may be heat-curable. In such a case, a heat curing accelerator may be incorporated. Such a heat curing accelerator may be a known accelerator. Specific examples may, for example, be azobisisobutyronitrile, benzoyl peroxide, tert-butyl hydroperoxide, cumene hydroperoxide, di-tert-butyl peroxide, dicumyl peroxide.

The content of the heat curing accelerator is preferably from 0.1 to 10 mass%, based on the total amount (100 mass%) of the curable composition.

<Additives>

To the curable composition, at least one additive selected from the group consisting of various additives well known in the coating field, for example, stabilizers such as an ultraviolet absorber, an antioxidant, a thermal polymerization preventing agent, etc.; surfactants such as a leveling agent, a defoaming agent, a precipitation-preventing agent, a dispersant; plasticizers; and thickeners, may be incorporated, as the case requires.

Further, in a case where the cured film is a material remaining as a functional component in a final product without being removed during the production process (hereinafter referred to as a component material), for example, like an interlayer dielectric film, an adhesion-improving agent such as a silane coupling agent may be incorporated to the curable composition. It is preferred to incorporate an adhesion-improving agent to the curable composition, since the adhesion between the substrate and the cured film of the curable composition will be improved. Otherwise, the adhesion between the substrate and the cured film can be improved also by a method of preliminarily applying an adhesion-improving agent to the substrate.

The blend amount of the additives is preferably from 0.01 to 10 mass%, as their total amount, based on the entire amount (100 mass%) of the curable composition.

<Cured film>

The cured film of the present invention is a film obtainable by curing the above described curable composition. It is preferably a film obtained by applying the above-described curable composition on a substrate and curing it by heating. Otherwise, in the case of a photocurable composition, a cured film is obtainable by applying a photocurable composition on a substrate, followed by prebaking, as the case requires, and then by irradiation (exposure) with light (e.g. ultraviolet rays). After irradiation with light, heating may be carried out, as the case requires. It is also possible to apply fine processing by photolithography.

The heating temperature to cure the curable composition is from 100 to 350°C, preferably from 150 to 250°C.

Further, the temperature for prebaking the photocurable composition is preferably from 40 to 100°C, and the temperature for heating (final baking) after irradiation with light is preferably from 100 to 350°C.

The thickness of the cured film is not particularly limited and may suitably be set depending upon the particular application. For example, the thickness is preferably at a level of from 0.1 to 100 $\mu$m, more preferably from 1 to 50 $\mu$m

The curable composition of the present invention is capable of forming a cured film having a low dielectric constant and is excellent in embedding planarity at the time of film formation. Accordingly, the cured film of the present invention has a low dielectric constant and is excellent in the surface planarity even when formed on a surface having convexoconcaves. Further, it is excellent also in heat resistance. Such a cured film is suitable as a component material such as an insulating film formed directly or via a passivation film (made of e.g. silicon nitride or polyimide) on a substrate such as a semiconductor.

Further, as shown in Examples given hereinafter, a high light transmittance and high transparency can be realized, and it is suitable as a highly transparent low dielectric material.

Further, it is excellent in the heat resistance and transparency, and a good flat surface is thereby obtainable, and thus, the curable composition is useful also as an embedding material or an adhesive to fix an optical component such as a light-emitting device.

EXAMPLES

Now, the present invention will be described in detail with reference to the following Examples and Comparative Examples, but it should be understood that the present invention is by no means thereby restricted.

In Examples and Comparative Examples, as the basic properties of a cured film, the relative dielectric constant, the light transmittance, the thermogravimetry and the planarity were measured by the following methods.

CURED FILM-PRODUCTION EXAMPLE 1

A sample liquid prepared as described hereinafter was filtered through a polytetrafluoroethylene (PTFE) filter having a pore diameter of 0.5 μm. The obtained filtrate was applied on a substrate by a spin coating method. The spinning condition was from 1,000 to 3,000 rpm for 30 seconds. The obtained coating film was prebaked by a hot plate under heating conditions of 100°C for 90 seconds, and then final baking was carried out in a vertical furnace at 300°C for 30 minutes in a nitrogen atmosphere to obtain a cured film.

[Relative dielectric constant]

In Cured Film-Production Example 1, a cured film having a thickness of about 1 μm was formed by using a silicon wafer with a diameter of 4 inches, as the substrate.

The obtained cured film was subjected to CV (Cyclic Voltammetry) measurement by a mercury prober (tradename: SSM-495, manufactured by SSM) to obtain a relative dielectric constant at 1 MHz. As the thickness of the cured film, a value obtained by means of a spectroscopic ellipsometer was used (the same applies hereinafter).

[Transmittance]

In Cured Film-Production Example 1, a cured film having a thickness of about 1 μm was formed by using a glass plate of 5 cm square as the substrate.

With respect to the obtained cured film, the light transmittance (unit: %) with a wavelength of 400 nm was measured by a spectrophotometer (tradename: UV-31 00, manufactured by Shimadzu Corporation).

[Thermogravimetric analysis]

In Cured Film-Production Example 1, a cured film having a thickness of about 1 μm was formed by using a silicon wafer with a diameter of 4 inches, as the substrate.

The obtained cured film was powdered and used as a test sample, and the thermogravimetric analysis was carried out by means of MTC1000S (tradename) manufactured by MAC Science Co., Ltd. As the analytical conditions, the temperature was raised from room temperature to 600°C at a rate of 10°C per minute. The 1% weight loss temperature and the 3% weight loss temperature were measured.

[Evaluation of Planarity]

In Cured Film-Production Example 1, using a silicon wafer having a pattern (line width: 5 μm, space width: 5 μm, depth: 0.5 μm) formed, as a substrate, a cured film having a thickness of about 0.6 μm was formed on the pattern.

By means of a scanning electron microscope (SEM), the cross sectional shape of the substrate having the cured film formed thereon was observed to evaluate the degree of planarization of the cured film. The degree of planarization (unit: %) was obtained by the following formula (I). The degree of planarization at the time when the pattern on the silicon wafer was completely planarized, is 100%.

Degree of planarization = [1-(concave depth of the cured film at the concave portion) / (depth of the concave portion)] × 100 (I)

[Exposure]

The exposure was carried out by irradiation with light of an ultrahigh pressure mercury lamp by means of UL-7000 (manufactured by Quintel). Here, with respect to a non-exposed portion, a light-shielding portion was formed by using a metal foil or mask.

PREPARATION EXAMPLE 1

Fluorinated polyarylene ether prepolymer (A1) was prepared as follows.

That is, in an N,N-dimethylacetamide (hereinafter referred to as DMAc) (6.2 kg) solvent, perfluorobiphenyl (650 g) and 1,3,5-trihydroxybenzene (120 g) were reacted at 40°C for 6 hours in the presence of potassium carbonate (570 g), and then, continuously 4-acetoxystyrene (200 g) was reacted in the presence of a 48 mass% potassium hydroxide aqueous solution (530 g) to prepare prepolymer (A1). A DMAc solution of obtained prepolymer (A1) was put into a

hydrochloric acid aqueous solution (3.5 mass% aqueous solution) for reprecipitation purification, followed by vacuum drying to obtain 800 g powdery prepolymer (A1).

EXAMPLE 1: Prepolymer (A)/compound (B) = 80/20 (mass% ratio)

In a sample bottle, 1.6 g of prepolymer (A1) obtained in Preparation Example 1 as the prepolymer (A), 0.4 g of dipentaerythritol hexaacrylate (tradename: NK ester A-DPH, manufactured by Shin-Nakamura Chemical Co., Ltd., molecular weight: 578, hereinafter referred to as ADPH) as the compound (B) and 8.0 g of PGMEA (propylene glycol monomethyl ether acetate) as a solvent, were put and dissolved to prepare a sample liquid.

EXAMPLE 2: Prepolymer (A)/compound (B) = 60/40 (mass% ratio)

A sample liquid was prepared in the same manner as in Example 1 except that in Example 1, the amount of prepolymer (A1) was changed to 1.2 g, and the amount of ADPH was changed to 0.8 g.

EXAMPLE 3: Prepolymer (A)/compound (B) = 40/60 (mass% ratio)

A sample liquid was prepared in the same manner as in Example 1 except that in Example 1, the amount of prepolymer (A1) was changed to 0.8 g, and the amount of ADPH was changed to 1.2 g.

## COMPARATIVE EXAMPLE 1: Prepolymer (A)/compound (B) = 100/0 (mass% ratio)

A sample liquid was prepared in the same manner as in Example 1 except that in Example 1, the amount of prepolymer (A1) was changed to 2.0 g, and no ADPH was added.

## COMPARATIVE EXAMPLE 2: Prepolymer (A)/compound (B) = 0/100 (mass% ratio)

A sample liquid was prepared in the same manner as in Example 1 except that in Example 1, no prepolymer (A1) was used.

[Evaluation of cured films]

The sample liquids (curable compositions) obtained in Examples 1 to 3 and Comparative Examples 1 and 2, cured films were formed based on the above described Cured Film-Production Example 1, and various properties were evaluated by the above described methods. The results are shown in Table 1.

In Table 1, the mass ratio of prepolymer (A1) to the compound (B) i.e. ADPH contained in each sample liquid (curable composition) is shown (the same applies hereinafter).

EXAMPLE 4: Prepolymer (A)/compound (B) = 95/5 (mass% ratio), photocuring

In a sample bottle, 4.5 g of prepolymer (A1) obtained in Preparation Example 1 as the prepolymer (A), 0.225 g of ADPH as the compound (B), 0.225 g of IRGACURE OXE01 (manufactured by Ciba Specialty Chemicals K.K.) as a photosensitizer and 5.05 g of PGMEA as a solvent were put and dissolved to prepare a sample liquid.

The sample liquid was spin-coated on a silicon wafer at a rotational speed of 1,000 rpm for 30 seconds and heated by a hot plate at 100°C for 90 seconds. Then, exposure was carried out with an irradiation energy of 500 $mJ/cm^2$, and then using PGMEA, paddle development was carried out for 2 minutes. Then, spin drying was carried out at a rotational speed of 2,000 rpm for 30 seconds, and further, heating was carried out by a hot plate at 100°C for 90 seconds. The film thickness at the exposed portion was 20 μm. This film thickness was 95% of the reference film thickness where no development step was carried out after the exposure. In the following Examples, a numerical value in brackets following the film thickness represents the proportion of the thickness to such a reference film thickness. The film thickness at the non-exposed portion at that time was 0.1 μm. Then, final baking was carried out in a vertical furnace at 300°C for 30 minutes in a nitrogen atmosphere to obtain a cured film.

EXAMPLE 5: Prepolymer (A)/compound (B) = 60/40 (mass% ratio), photocuring

In a sample bottle, 1.8 g of prepolymer (A1) obtained in Preparation Example 1 as the prepolymer (A), 1.2 g of ADPH as the compound (B), 0.15 g of IRGACURE OXE01 as a photosensitizer and 6.85 g of PGMEA as a solvent were put and dissolved to prepare a sample liquid.

This liquid was spin-coated on a silicon wafer at a rotational speed of 2,000 rpm for 30 seconds and heated by a hot plate at 70°C for 90 seconds. Then, exposure was carried out with an irradiation energy of 500 mJ/$cm^2$, followed by paddle development for 2 minutes by means of PGMEA. Then, spin drying was carried out at a rotational speed of 2,000 rpm for 30 seconds, and further, heating by a hot plate at 100°C for 90 seconds was carried out. The film thickness at the exposed portion was 2.0 μm (91 %), and the film thickness at the non-exposed portion was at most 0.1 μm. Then, final baking was carried out in a vertical furnace at 300°C for 30 minutes in a nitrogen atmosphere to obtain a cured film.

COMPARATIVE EXAMPLE 3: Example wherein no compound B was used

In a sample bottle, 1.6 g of prepolymer (A1) obtained in Preparation Example 1 as the prepolymer (A), 0.4 g of oligomerized BANI-X (manufactured by Maruzen Petrochemical Co., Ltd., number average molecular weight: 6,000) instead of the compound (B) and 8.0 g of PGMEA as a solvent were put and dissolved to prepare a sample liquid.

Using the obtained sample liquid (curable composition), a cured film was formed in the same manner as in Example 1, whereby the obtained cured film was clouded. This is considered attributable to a phase separation due to poor compatibility of the oligomerized BANI-X and prepolymer (A1).

Also with respect to the cured films obtained in Examples 4 and 5, various properties were evaluated by the above described methods. The results are shown in Table 1.

Here, "-" in Table 1 means "not evaluated".

TABLE 1

| | Mass ratio | | Relative dielectric constant | Transmittance (400 nm) | Thermogravimetric analysis | | Degree of planarization |
|---|---|---|---|---|---|---|---|
| | Prepolymer (A1) | Compound (B) | | | 1% weight loss temperature | 3% weight loss temperature | |
| Comp. Ex. 1 | 100 | 0 | 2.5 | 99% | 415 | 450 | 35% |
| Ex. 1 | 80 | 20 | 2.8 | 99% | 380 | 420 | 68% |
| Ex. 2 | 60 | 40 | 3.1 | 99% | 340 | 400 | 100% |
| Ex. 3 | 40 | 60 | 3.5 | 99% | 250 | 390 | 100% |
| Comp. Ex. 2 | 0 | 100 | 4.6 | 99% | 100 | 350 | - |
| Ex. 4 | 95 | 5 | 2.6 | 99% | 410 | 430 | 50% |
| Ex. 5 | 60 | 40 | 3.1 | 99% | 340 | 400 | 100% |

As shown in Table 1, cured films formed by using the curable compositions in Examples 1 to 5 have low relative dielectric constants, high light transmittance, high heat resistance and excellent embedding planarity of convexoconcaves.

Whereas, in Comparative Example 1 wherein no compound (B) was incorporated, the specific dielectric constant is low, and although the heat resistance is excellent, the degree of planarization is low. Further, in Comparative Example 2 wherein no prepolymer (A1) was incorporated, the relative dielectric constant is high, and the heat resistance is low. Further, in Comparative Example 2 and 3, the film forming properties were poor and it was difficult to prepare a desired sample for evaluation, and therefore no measurement of the degree of planarization was carried out.

INDUSTRIAL APPLICABILITY

The curable composition of the present invention presents a cured film which is excellent in embedding planarity at the time of film formation and which has a low dielectric constant and thus is useful as a highly transparent low dielectric constant material in the field of electronics, or as an adhesive, embedding material or the like to fix an optical component such as a light-emitting device.

## Claims

**1.** A curable composition comprising a fluorinated polyarylene prepolymer (A) having a crosslinkable functional group, and a compound (B) having a crosslinkable functional group and having no fluorine atoms, wherein the crosslinkable functional group of the fluorinated polyarylene prepolymer (A) is at least one member selected from the group consisting of a vinyl group, a methacryloyl(oxy) group, an acryloyl(oxy) group, a trifluorovinyloxy group, an ethynyl group, a cyclobutarene ring or an oxirane ring, and wherein the compound (B) is dipentaerythritol triacrylate triundecylate, dipentaerythritol pentaacrylate monoundecylate, ethoxylated isocyanuric acid triacrylate, ε-caprolactone-modified tris-(2-acryloxyethyl) isocyanurate, dipentaerythritol polyacrylate, 9,9-bis[4-(2-acryloyloxyethoxy)phenyl] fluorene, polyethylene glycol diacrylate, polyethylene glycol dimethacrylate, polypropylene glycol diacrylate, polypropylene glycol dimethacrylate, ethoxylated bisphenol A diacrylate, ethoxylated bisphenol A dimethacrylate, propoxylated bisphenol A diacrylate, propoxylated bisphenol A dimethacrylate, 1,10-decanediol diacrylate, 1,6-hexanediol diacrylate, 1,6-hexanediol dimethacrylate, 1,4-butanediol dimethacrylate, 1,3-butanediol dimethacrylate, hydroxypivalic acid neopentyl glycol diacrylate, 1,9-nonanediol diacrylate, 1,9-nonanediol dimethacrylate, neopentyl glycol diacrylate, neopentyl glycol dimethacrylate, pentaerythritol triacrylate, trimethylolpropane triacrylate, trimethylolpropane trimethacrylate, ethoxylated trimethylolpropane triacrylate, propoxylated trimethylolpropane triacrylate, triallyl cyanurate, triallyl isocyanurate, trimethaallyl isocyanurate, 1,4-butanediol divinyl ether, 1,9-nonanediol divinyl ether, cyclohexane dimethanol divinyl ether, triethylene glycol divinyl ether, trimethylolpropane trivinyl ether, pentaerythritol tetravinyl ether, 2-(2-vinyloxyethoxy)ethyl acrylate, 2-(2-vinyloxyethoxy)ethyl methacrylate, trimethylolpropane diallyl ether, pentaerythritol triallyl ether, dipentaerythritol hexaacrylate, pentaerythritol tetraacrylate, propoxylated dipentaerythritol hexaacrylate, dioxane glycol diacrylate, an ethoxylated pentaerythritol tetraacrylate represented by the following formula (1), a propoxylated pentaerythritol tetraacrylate represented by the following formula (2), ditrimethylolpropane tetraacrylate, tricyclodecane dimethanol diacrylate, tricyclodecane dimethanol methacrylate, and a compound represented by the following formula (3):

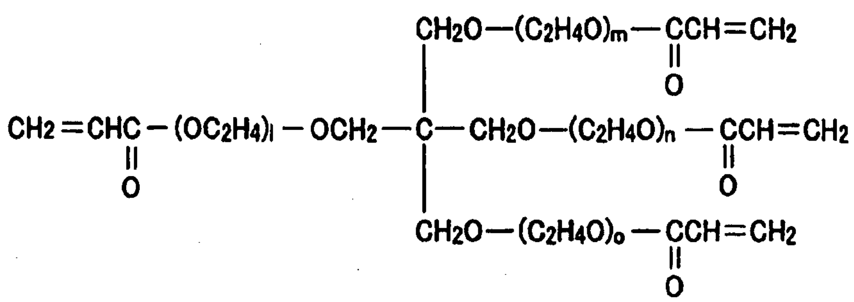

···(1)

(In the formula, l+m+n+o is from 4 to 35.)

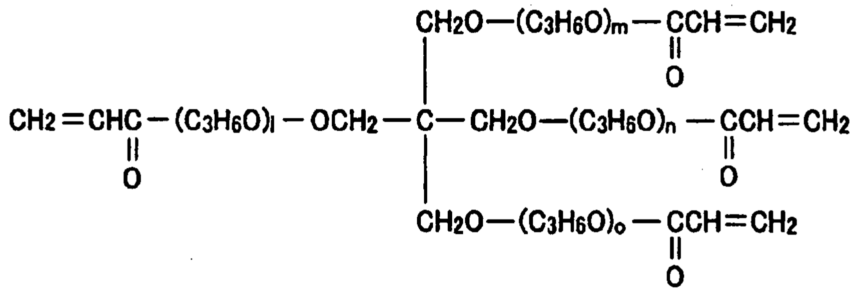

···(2)

(In the formula, l+m+n+o is about 4.)

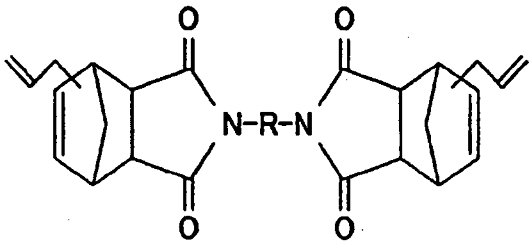

···(3)

(In the formula, R is

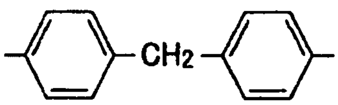

, or

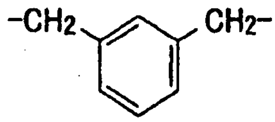

)

2. The curable composition according to Claim 1, wherein the proportion of the fluorinated polyarylene prepolymer (A) is from 3 to 97 mass%, based on the total mass of the fluorinated polyarylene prepolymer (A) and the compound (B).

3. The curable composition according to Claim 1 or 2, wherein the prepolymer (A) is a prepolymer obtainable by reacting, in the presence of a dehydro halogenating agent; perfluoro(1,3,5-triphenylbenzene) or perfluorobiphenyl; 1,3,5-trihydroxybenzene or 1,1,1-tris(4-hydroxyphenyl)ethane; and pentafluorostyrene, acetoxystyrene or chloromethylstyrene.

4. The curable composition according to Claim 3, wherein the dehydro halogenating agent is potassium carbonate.

5. The curable composition according to any one of Claims 1 to 4, wherein the compound (B) is dipentaerythritol hexaacrylate.

6. The curable composition according to any one of Claims 1 to 5, which further contains a solvent.

7. The curable composition according to Claim 6, wherein the solvent is propylene glycol monomethyl ether acetate.

8. The curable composition according to any one of Claims 1 to 7, which further contains a photosensitizer.

9. A cured film obtainable by curing the curable composition as defined in any one of Claims 1 to 8.

10. The cured film according to Claim 9, wherein the curing is carried out by heating or light irradiation.

11. The cured film according to Claim 9 or 10 obtainable by applying the curable composition as defined in any one of Claims 1 to 8 on a substrate to form a curable composition film, prebaking it at a temperature of from 40 to 100°C, irradiating it with light, developing and then heating it at a temperature of from 100 to 350°C.

12. The cured film according to any one of Claims 9 to 11, which has a thickness of from 0.1 to 100 μm.

**Patentansprüche**

1. Härtbare Zusammensetzung, umfassend ein fluoriertes Polyarylenvorpolymer (A) mit einer vernetzbaren funktionellen Gruppe, und eine Verbindung (B) mit einer vernetzbaren funktionellen Gruppe und ohne Fluoratome, wobei die vernetzbare funktionellen Gruppe des fluorierten Polyarylenvorpolymers (A) mindestens ein Vertreter, ausgewählt aus der Gruppe, bestehend aus einer Vinylgruppe, einer Methacryloyl(oxy)gruppe, einer Acryloyl(oxy)gruppe, einer Trifluorvinyloxygruppe, einer Ethinylgruppe, einem Cyclobutarenring oder einem Oxiranring ist, und wobei die Verbindung (B) Dipentaerythritoltriacrylattriundecylat, Dipentaerythritolpentaacrylatmonoundecylat, ethoxyliertes Isocyanursäuretriacrylat, ε-caprolactonmodifiziertes Tris-(2-acryloxyethyl)isocyanurat, Dipentaerythritolpolyacrylat, 9,9-Bis[4-(2-acryloyloxyethoxy)phenyl]fluoren, Polyethylenglycoldiacrylat, Polyethylenglycoldimethacrylat, Polypropylenglycoldiacrylat, Polypropylenglycoldimethacrylat, ethoxyliertes Bisphenol-A-diacrylat, ethoxyliertes Bisphenol-A-dimethacrylat, propoxyliertes Bisphenol-A-diacrylat, propoxyliertes Bisphenol-A-dimethacrylat, 1,10-Dekandioldiacrylat, 1,6-Hexandioldiacrylat, 1,6-Hexandioldimethacrylat, 1,4-Butandioldimethacrylat, 1,3-Butandioldimethacrylat, Hydroxypivalinsäureneopentylglycoldiacrylat, 1,9-Nonandioldiacrylat, 1,9-Nonandioldimethacrylat, Neopentylglycoldiacrylat, Neopentylglycoldimethacrylat, Pentaerythritoltriacrylat, Trimethylolpropantriacrylat, Trimethylolpropantrimethacrylat, ethoxyliertes Trimethylolpropantriacrylat, propoxyliertes Trimethylolpropantriacrylat, Triallylcyanurat, Triallylisocyanurat, Trimethallylisocyanurat, 1,4-Butandioldivinylether, 1,9-Nonandioldivinylether, Cyclohexandimethanoldivinylether, Triethylenglycoldivinylether, Trimethylolpropantrivinylether, Pentaerythritoltetravinylether, 2-(2-Vinyloxyethoxy)ethylacrylat, 2-(2-Vinyloxyethoxy)ethylmethacrylat, Trimethylolpropandiallylether, Pentaerythritoltriallylether, Dipentaerythritolhexaacrylat, Pentaerythritoltetraacrylat, propoxyliertes Dipentaerythritolhexaacrylat, Dioxanglycoldiacrylat, ein ethoxyliertes Pentaeryhtritoltetraacrylat, dargestellt durch die folgende Formel (1), ein propoxyliertes Pentaerythritoltetraacrylat, dargestellt durch die folgende Formel (2), Ditrimethylolpropantetraacrylat, Tricyclodekandimethanoldiacrylat, Tricyclodekandimethanolmethacrylat, und eine Verbindung dargestellt durch die folgende Formel (3), ist:

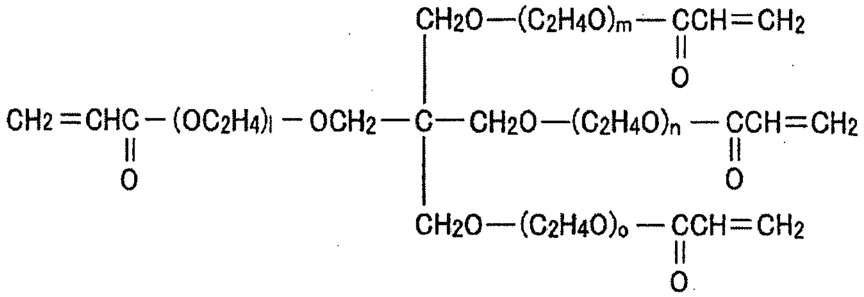

···(1)

(in der Formel ist l+m+n+o von 4 bis 35)

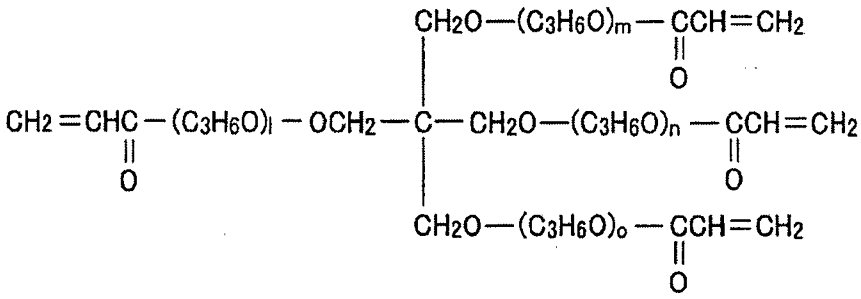

···(2)

(in der Formel ist l+m+n+o etwa 4)

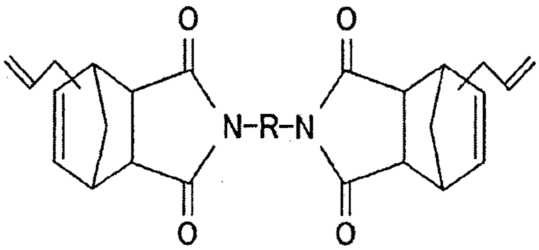

···(3)

(in der Formel ist R

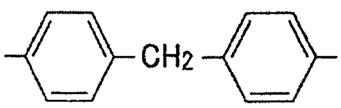

, oder

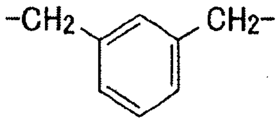

)

2. Härtbare Zusammensetzung nach Anspruch 1, wobei der Anteil des fluorierten Polyarylenvorpolymers (A) 3 bis 97 Gew.-%, bezogen auf das Gesamtgewicht des fluorierten Polyarylenvorpolymers (A) und der Verbindung (B), ist.

3. Härtbare Zusammensetzung nach Anspruch 1 oder 2, wobei das Vorpolymer (A) ein Vorpolymer ist, das durch Umsetzen von Perfluoro(1,3,5-triphenylbenzol) oder Perfluorbiphenyl, mit 1,3,5-Trihydroxybenzol oder 1,1,1-Tris(4-hydroxyphenyl)ethan, und Pentafluorstyrol, Acetoxystyrol oder Chloromethylstyrol, in Gegenwart eines dehydrohalogenierenden Mittels, erhältlich ist.

4. Härtbare Zusammensetzung nach Anspruch 3, wobei das dehydrohalogenierende Mittel Kaliumcarbonat ist.

5. Die härtbare Zusammensetzung nach einem der Ansprüche 1 bis 4, wobei die Verbindung B Dipentaerythritolhexaacrylat ist.

6. Härtbare Zusammensetzung nach einem der Ansprüche 1 bis 5, welche weiter ein Lösungsmittel enthält.

7. Härtbare Zusammensetzung nach Anspruch 6, wobei das Lösungsmittel Propylenglycolmonomethyletheracetat ist.

**8.** Härtbare Zusammensetzung nach einem der Ansprüche 1 bis 7, welche weiter einen Photosensibilisator enthält.

**9.** Gehärteter Film, erhältlich durch Härten der härtbaren Zusammensetzung wie in einem der Ansprüche 1 bis 8 definiert.

**10.** Gehärteter Film nach Anspruch 9, wobei das Härten durch Erwärmen oder Lichteinstrahlung ausgeführt wird.

**11.** Gehärteter Film nach Anspruch 9 oder 10, erhältlich durch Aufbringen der härtbaren Zusammensetzung, wie in einem der Ansprüche 1 bis 8 definiert, auf ein Substrat, um einen härtbaren Film der Zusammensetzung zu bilden, das Vorerwärmen bei einer Temperatur von 40 bis 100 °C, das Bestrahlen mit Licht, um sie zu entwickeln, und dann Erwärmen bei einer Temperatur von 100 bis 350 °C.

**12.** Gehärteter Film nach einem der Ansprüche 9 bis 11, welcher eine Dicke von 0,1 bis 100 μm hat.

## Revendications

**1.** Composition durcissable comprenant un prépolymère de polyarylène fluoré (A) contenant un groupe fonctionnel réticulable, et un composé (B) contenant un groupe fonctionnel réticulable et ne contenant aucun atome de fluor, dans laquelle le groupe fonctionnel réticulable du prépolymère de polyarylène fluoré (A) est au moins un membre choisi dans le groupe constitué par un groupe vinyle, un groupe méthacryloyl(oxy), un groupe acryloyl(oxy), un groupe trifluorovinyloxy, un groupe éthynyle, un cycle cyclobutarène ou un cycle oxirane, et dans laquelle le composé (B) est le triundécylate de triacrylate de dipentaérythritol, le monoundécylate de pentaacrylate de dipentaérythritol, le triacrylate d'acide isocyanurique éthoxylé, l'isocyanurate de tris-(2-acryloxyéthyl) modifié par 1' c-caprolactone, un poly(acrylate de dipentaérythritol), le 9,9-bis[4-(2-acryloyloxyéthoxy)phényl]fluorène, le diacrylate de polyéthylène glycol, le diméthacrylate de polyéthylène glycol, le diacrylate de polypropylène glycol, le diméthacrylate de polypropylène glycol, le diacrylate de bisphénol A éthoxylé, le diméthacrylate de bisphénol A éthoxylé, le diacrylate de bisphénol A propoxylé, le diméthacrylate de bisphénol A propoxylé, le diacrylate de 1,10-décanediol, le diacrylate de 1,6-hexanediol, le diméthacrylate de 1,6-hexanediol, le diméthacrylate de 1,4-butanediol, le diméthacrylate de 1,3-butanediol, le diacrylate de l'acide hydroxypivalique néopentyl glycolé, le diacrylate de 1,9-nonanediol, le diméthacrylate de 1,9-nonanediol, le diacrylate de néopentyl glycol, le diméthacrylate de néopentyl glycol, le triacrylate de pentaérythritol, le triacrylate de triméthylolpropane, le triméthacrylate de triméthylol-propane, le triacrylate de triméthylolpropane éthoxylé, le triacrylate de triméthylolpropane propoxylé, le cyanurate de triallyle, l'isocyanurate de triallyle, l'isocyanurate de triméthaallyle, le 1,4-butanediol divinyl éther, le 1,9-nonanediol divinyl éther, le cyclohexane diméthanol divinyl éther, le triéthylène glycol divinyl éther, le triméthylolpropane trivinyl éther, le pentaérythritol tétravinyl éther, l'acrylate de 2-(2-vinyloxyéthoxy)-éthyle, le méthacrylate de 2-(2-vinyloxyéthoxy)éthyle, le triméthylolpropane diallyl éther, le pentaérythritol triallyl éther, l'hexaacrylate de dipentaérythritol, le tétraacrylate de pentaérythritol, l'hexaacrylate de dipentaérythritol propoxylé, le diacrylate de dioxane glycol, un tétraacrylate de pentaérythritol éthoxylé représenté par la formule (1) suivante, un tétraacrylate de pentaerythritol propoxylé représenté par la formule (2) suivante, le tétraacrylate de ditriméthylolpropane, le diacrylate de tricyclodécane diméthanol, le méthacrylate de tricyclodécane diméthanol et un composé représenté par la formule (3) suivante :

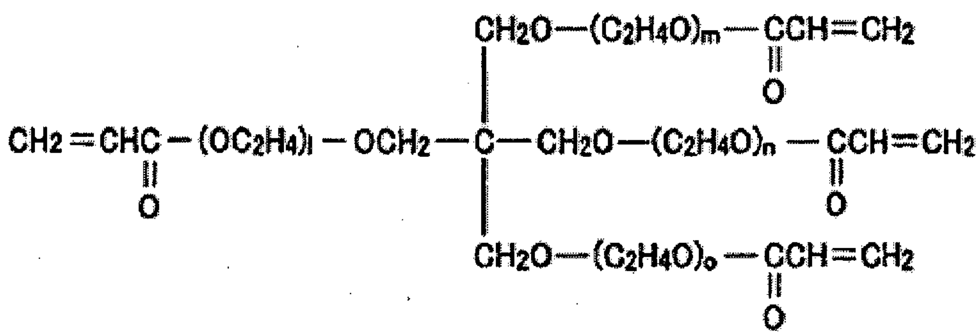

···(1)

(dans la formule, l+m+n+o va de 4 à 35)

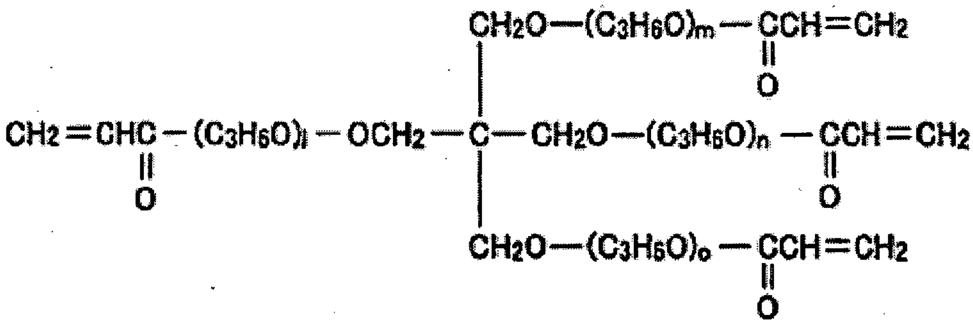 ···(2)

(dans la formule, l+m+n+o est environ 4)

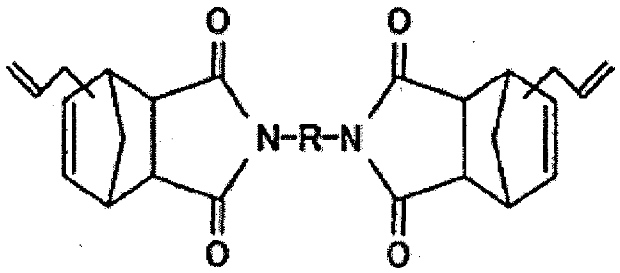 ···(3)

(dans la formule, R est

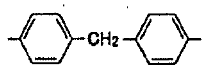 ou 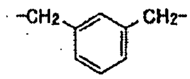

).

2. Composition durcissable selon la revendication 1, dans laquelle la proportion du prépolymère de polyarylène fluoré (A) est de 3 % à 97 % en poids, sur la base du poids total du prépolymère de polyarylène fluoré (A) et du composé (B).

3. Composition durcissable selon la revendication 1 ou 2, dans laquelle le prépolymère (A) est un prépolymère pouvant être obtenu par la réaction, en présence d'un agent de déshydro-halogénation ; du perfluoro(1,3,5-triphénylbenzène) ou du perfluorobiphényle ; du 1,3,5-trihydroxybenzène ou du 1,1,1-tris-(4-hydroxyphényl)éthane ; et du pentafluorostyrène, de l'acétoxystyrène ou du chlorométhylstyrène.

4. Composition durcissable selon la revendication 3, dans laquelle l'agent de déshydrohalogénation est le carbonate de potassium.

5. Composition durcissable selon l'une quelconque des revendications 1 à 4, dans laquelle le composé (B) est l'hexaacrylate de dipentaérythritol.

6. Composition durcissable selon l'une quelconque des revendications 1 à 5, qui contient en outre un solvant.

7. Composition durcissable selon la revendication 6, dans laquelle le solvant est l'acétate de propylène glycol monométhyl éther.

8. Composition durcissable selon l'une quelconque des revendications 1 à 7, qui contient en outre un photosensibilisateur.

9. Film durci, pouvant être obtenu par le durcissement de la composition durcissable telle que définie dans l'une quelconque des revendications 1 à 8.

10. Film durci selon la revendication 9, dans lequel le durcissement est réalisé en chauffant ou sous irradiation lumineuse.

**11.** Film durci selon la revendication 9 ou 10, qui peut être obtenu par l'application de la composition durcissable telle que définie dans l'une quelconque des revendications 1 à 8 sur un substrat pour former un film de composition durcissable, sa cuisson préalable à une température de 40° C à 100° C, son irradiation avec une lumière, son développement puis son chauffage à une température de 100° C à 350° C.

**12.** Film durci selon l'une quelconque des revendications 9 à 11, qui possède une épaisseur de 0,1 μm à 100 μm.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6361926 B
- WO 038483 A
- JP 10074750 A
- WO 2006137327 A
- JP 7503740 A
- WO 2007119384 A
- JP 2007186608 A
- JP 2007188741 A
- EP 1897897 A
- US 5250667 A
- US 2005107569 A